# EUROPEAN PATENT SPECIFICATION

(11) **EP 2 779 220 B1**
(45) Date of publication and mention of the grant of the patent: **25.10.2017**
(21) Application number: 14157461.6
(22) Date of filing: 03.03.2014
(51) Int. Cl.: H01L 21/66

(54) **Saturation voltage estimation method and silicon epitaxial wafer manufaturing method**
Sättigungsspannungsschätzverfahren und Silizium-Epitaxialwaferherstellungsverfahren
Procédé d'estimation de tension de saturation et procédé de fabrication de tranche épitaxiale de silicium

(30) Priority: 12.03.2013 JP 2013049057
(43) Date of publication of application: 17.09.2014
(73) Proprietor: GlobalWafers Japan Co., Ltd., Niigata 957-0197 (JP)
(72) Inventor: Nakagawa, Satoko, Tokyo (JP); Kashima, Kazuhiko, Tokyo (JP)
(74) Representative: Fuchs Patentanwälte Partnerschaft mbB

(56) References cited:
- JP-A- 2010 034 281
- JP-A- 2012 009 581
- US-A- 4 812 756
- NAKAMURA M ET AL: "PHOTOLUMINESCENCE MEASUREMENT OF CARBON IN SILICON CRYSTALS IRRADIATED WITH HIGH ENERGY ELECTRONS", JOURNAL OF THE ELECTROCHEMICAL SOCIETY, ELECTROCHEMICAL SOCIETY, vol. 141, no. 12, 1 December 1994 (1994-12-01), pages 3576-3580, XP002031356, ISSN: 0013-4651
- SATOKO NAKAGAWA-TOYOTA ET AL: "Characterization of Light Element Impurities in Ultrathin Silicon-on-Insulator Layers by Luminescence Activation Using Electron Irradiation", JAPANESE JOURNAL OF APPLIED PHYSICS, vol. 48, no. 3, 23 March 2009 (2009-03-23) , page 031201, XP055222281, JP ISSN: 0021-4922, DOI: 10.1143/JJAP.48.031201
- NAKAGAWA S ET AL: "Photoluminescence evaluation of light element impurities in ultrathin SOI wafers by luminescence activation using electron irradiation", MATERIALS SCIENCE AND ENGINEERING B, ELSEVIER SEQUOIA, LAUSANNE, CH, vol. 134, no. 2-3, 15 October 2006 (2006-10-15), pages 172-175, XP027953692, ISSN: 0921-5107 [retrieved on 2006-10-15]

## Description

### FIELD

The present invention relates to a saturation voltage estimation method and a silicon epitaxial wafer manufacturing method using the same. In particular, the present invention relates to an estimation method of estimating a collector-emitter saturation voltage before fabricating a semiconductor device including a collector and emitter from a silicon epitaxial wafer manufactured through an epitaxial method and including a silicon layer with a carbon concentration of 5 × 10¹⁴ atoms/cm³ or less as an epitaxial layer, and further relates to a silicon epitaxial wafer manufacturing method using this estimation method.

### BACKGROUND

Many recently developed power devices are aiming at high breakdown voltages. The carbon concentration in an epitaxial layer of a silicon epitaxial wafer has an influence when increasing the breakdown voltage of a power device. Therefore, demands have arisen for further reducing this carbon concentration.

A practically required carbon concentration is 5 × 10¹⁴ atoms/cm³ or less. It is being required to stably manufacture and supply a silicon epitaxial wafer in which the carbon concentration is thus very low, while controlling the carbon concentration in accordance with the standards of a device.

Unfortunately, a method of evaluating a carbon concentration of 5 × 10¹⁴ atoms/cm³ or less is not defined in the Japanese Industrial Standards (JIS) and Semiconductor Equipment and Materials International (SEMI) standards. An example of the carbon concentration evaluation method is secondary ion mass spectrometry (SIMS) capable of evaluating the carbon concentration of a thin film. However, the detection limit of the method is about 1 × 10¹⁵ atoms/cm³, i.e., it is difficult for the method to evaluate a carbon concentration of 5 × 10¹⁴ atoms/cm³ or less.

As another evaluation method, Jpn. Pat. Appln. KOKAI Publication No. 4-344443 has proposed a method capable of measuring the carbon concentration in silicon at a high sensitivity by measuring the intensity of light generated by irradiating a silicon sample with an electron beam (a photoluminescence method), and performing the same measurement after carbon or oxygen ions are implanted. However, this literature does not indicate any measureable carbon concentration. In addition, since ion implantation is performed, luminescence caused by implantation damage and irrelevant to a carbon impurity, or non-radiative centers that have a carbon defect level but do not emit light increase. This makes it difficult to accurately evaluate the concentration of carbon originally contained in silicon.

As still another method, J. Weberand and M. Singh describe in Appl. Phys. Lett. 49(23), 1986 that when luminescence measurement is performed on a sample whose carbon concentration is measured by infrared absorption spectroscopy (IR) and the relationship between the carbon concentration obtained by the IR method and the intensity obtained by the luminescence measurement is obtained, an unknown carbon concentration of a sample can be estimated by performing luminescence measurement on the sample.

Unfortunately, the lowest carbon concentration evaluated by IR is 8.7 × 10¹⁵ atoms/cm³. Also, the detection limit of IR is at most about 1 × 10¹⁵ atoms/cm³, so IR cannot measure a carbon concentration lower than this detection limit. For a sample having a low carbon concentration, therefore, the intensity obtained by luminescence measurement cannot be compared with the above-mentioned relationship, or the carbon concentration cannot estimated at a high accuracy. The publication of Nakamura et al. "Photoluminescence measurement of carbon in silicon crystals irradiated with high energy electrons" (Journal of the Electrochemical Society, Electrochemical Society, vol. 141, no. 12, December 1994, pages 3576-3580) discloses photoluminescence measurements on crystal silicon to determine a carbon concentration, and a relation between the obtained photoluminescence intensities and a carbon concentration in the silicon.

JP 2010 034281 A discloses a relation between the saturation voltage of a IGBT device and the carbon concentration in a silicon substrate.

### BRIEF SUMMARY

As described previously, it is conventionally known that the carbon concentration has an influence on the device characteristics. However, the relationship between the device characteristics and carbon having a very low concentration of 5 × 10¹⁴ atoms/cm³ or less is unknown. In addition, no evaluation method has been established for this carbon concentration as described above. Accordingly, it is impossible to optimize wafer manufacturing steps in order to achieve desired characteristics in a low-carbon-concentration device. This may have a serious influence on the yield of a device formation process.

An object of the present invention, therefore, is to provide a technique advantageous in forming a semiconductor device at a high yield from a silicon epitaxial wafer in which the carbon concentration of an epitaxial layer is 5 × 10¹⁴ atoms/cm³ or less.

In consideration of the above situation, the present inventors made extensive studies by focusing attention on the photoluminescence method. Consequently, the present inventors have found that the luminescence spectral intensity or intensity ratio of a low-carbon-concentration silicon epitaxial wafer in which the carbon concentration of an epitaxial layer is 5 × 10¹⁴ atoms/cm³ or less has a positive correlation with the saturation voltage of the collector-emitter path as a device characteristic, and have arrived at a saturation voltage estimation method of estimating the saturation voltage of the collector-emitter path before a device is formed.

That is, the present inventors have arrived at a saturation voltage estimation method of estimating the device characteristic (collector-emitter saturation voltage) before the fabrication of a device from the luminescence spectral intensity or intensity ratio of a silicon epitaxial wafer, instead of determining a carbon concentration of 5 × 10¹⁴ atoms/cm³ or less by the photoluminescence method.

In addition, the present inventors have arrived at a silicon epitaxial wafer manufacturing method of determining the quality of a silicon epitaxial wafer by using the saturation voltage estimation method.

According to a first aspect of the present invention, there is provided a saturation voltage estimation method comprising:
a first step of preparing a plurality of first lots each including two or more first silicon epitaxial wafers, the plurality of first lots being obtained by performing, a plurality of number of times, a process of simultaneously forming silicon layers having a carbon concentration of 5 × 10¹⁴ atoms/cm³ or less on two or more first wafers by epitaxial growth;
a second step of performing, for each of the plurality of first lots, irradiation of one or more of the two or more first silicon epitaxial wafers with a particle beam to render a carbon impurity in the silicon layer luminescence-active, irradiation of the silicon layer with excitation light to cause the luminescence, measurement of an intensity or intensity ratio of luminescence originating from the carbon impurity, fabrication of one or more semiconductor devices each including a collector and emitter from the rest of the two
   or more first silicon epitaxial wafers, and measurement of a collector-emitter
   saturation voltage of each of the devices, thereby obtaining a relationship between the intensity or intensity ratio and the saturation voltage;
a third step of preparing a second lot including two or more second silicon epitaxial wafers, the second lot being obtained by performing a process of simultaneously forming silicon layers having a carbon concentration of 5 × 10¹⁴ atoms/cm³ or less on two or more second wafers by epitaxial growth; and
a fourth step of irradiating one or more of the two or more second silicon epitaxial wafers with a particle beam to render a carbon impurity in the silicon layer active for luminescence, irradiating the silicon layer with excitation light to cause the luminescence, measuring an intensity or intensity ratio of luminescence originating from the carbon impurity, and comparing the intensity or intensity ratio thus obtained with the relationship to estimate a collector-emitter saturation voltage of a semiconductor device to be fabricated from the rest of the two or more second silicon epitaxial wafers and including a collector and emitter.

In the estimation method according to the first aspect, the collector-emitter saturation voltage can be estimated by measuring the luminescence of the silicon layer as an epitaxial layer. Accordingly, if it is estimated that a silicon epitaxial wafer in a certain manufacturing lot does not achieve a saturation voltage within an allowable range, the yield of a semiconductor device formation process can be increased by not supplying the other wafers of the same manufacturing lot to the process. Also, if it is estimated that a certain silicon epitaxial wafer does not achieve a saturation voltage within an allowable range, it is possible to predict that the manufacturing conditions of the wafer have deviated from optimum conditions. Therefore, the estimation method according to the first aspect facilitates maintaining the wafer manufacturing conditions in an optimum state, and can also increase the yield of the wafer manufacturing process.

According to a second aspect of the present invention, there is provided a silicon epitaxial wafer manufacturing method comprising:
a first step of preparing a plurality of first lots each including two or more first silicon epitaxial wafers, the plurality of first lots being obtained by performing, a plurality of number of times, a process of simultaneously forming silicon layers having a carbon concentration of 5 × 10¹⁴ atoms/cm³ or less on two or more first wafers by epitaxial growth;
a second step of performing, for each of the plurality of first lots, irradiation of one or more of the two or more first silicon epitaxial wafers with a particle beam to render a carbon impurity in the silicon layer luminescence-active, irradiation of the silicon layer
   with excitation light to cause the luminescence, measurement of an intensity or intensity ratio of luminescence originating from the carbon impurity, fabrication of one or more semiconductor devices each including a collector and emitter from the rest of the two or more first silicon epitaxial wafers, and measurement of a collector-emitter saturation voltage of each of the devices, thereby obtaining a relationship between the intensity or intensity ratio and the saturation voltage;
a third step of preparing a second lot including two or more second silicon epitaxial wafers, the second lot being obtained by performing a process of simultaneously forming silicon layers having a carbon concentration of 5 × 10¹⁴ atoms/cm³ or less on two or more second wafers by epitaxial growth; and
a fourth step of irradiating one or more of the two or more second silicon epitaxial wafers with a particle beam to render a carbon impurity in the silicon layer luminescence-active, irradiating the silicon layer with excitation light to cause the luminescence, measuring an intensity or intensity ratio of luminescence originating from the carbon impurity, and determining quality of the two or more second silicon epitaxial wafers from the intensity or intensity ratio measured on the two or more second silicon epitaxial wafers, the relationship, and a predetermined allowable range of a collector-emitter saturation voltage.

In the manufacturing method according to the second aspect, whether a semiconductor device having a collector-emitter saturation voltage falling within an allowable range can be fabricated from a silicon epitaxial wafer can be determined by measuring the luminescence of the silicon layer as an epitaxial layer. That is, the quality of the silicon epitaxial wafer can be determined before the semiconductor device is fabricated. Accordingly, the yield of the semiconductor device fabrication process increases. Also, if a silicon epitaxial wafer of a certain manufacturing lot is a defective product, it is possible to predict that the manufacturing conditions of the wafer have deviated from optimum conditions. Therefore, the manufacturing method according to the second aspect facilitates maintaining the wafer manufacturing conditions in an optimum state, and can also increase the yield of the wafer manufacturing process.

### BRIEF DESCRIPTION OF THE DRAWINGS

FIG. 1 is a schematic view showing luminescence-activation of a carbon impurity by electron beam radiation to a silicon wafer;
FIG. 2 is a chart showing an example of the luminescence spectrum of the silicon wafer;
FIG. 3 is a chart showing an example of the luminescence spectrum of an epitaxial layer;
FIG. 4 is a graph showing an example of the relationship between the intensity of luminescence (G-line luminescence) originating from a complex of interstitial carbon and substitutional carbon and a collector-emitter saturation voltage Vce(sat);
FIG. 5 is a graph showing an example of the relationship between the ratio of the G-line luminescence intensity to the free-exciton luminescence intensity (FE luminescence intensity) and the collector-emitter saturation voltage Vce(sat);
FIG. 6 is a flowchart showing a silicon epitaxial wafer manufacturing method according to an embodiment of the present invention; and
FIG. 7 is a graph showing an example of the ratio of the G-line luminescence intensity to the FE luminescence intensity.

### DETAILED DESCRIPTION

First, a principle used in an embodiment of the present invention will be explained.

This embodiment uses a photoluminescence method. The photoluminescence method is a conventionally known method by which electrons are excited by irradiating a material with excitation light, and light emitted when the excited electrons change to the ground state is observed.

More specifically, electron-hole pairs are formed when a semiconductor (silicon) is irradiated with light having energy higher than that of the forbidden band. Here, electron-hole pairs exceeding a thermal equilibrium state are formed in semiconductor (silicon) crystals. The excess electron-hole pairs recombine and return to an equilibrium state. Light is emitted in this recombination process. The spectrum of this emitted light is readily influenced by an impurity or defect in the semiconductor crystals. Therefore, information of a carbon impurity in the semiconductor (silicon) is obtained by spectroscopically precisely analyzing the light emission.

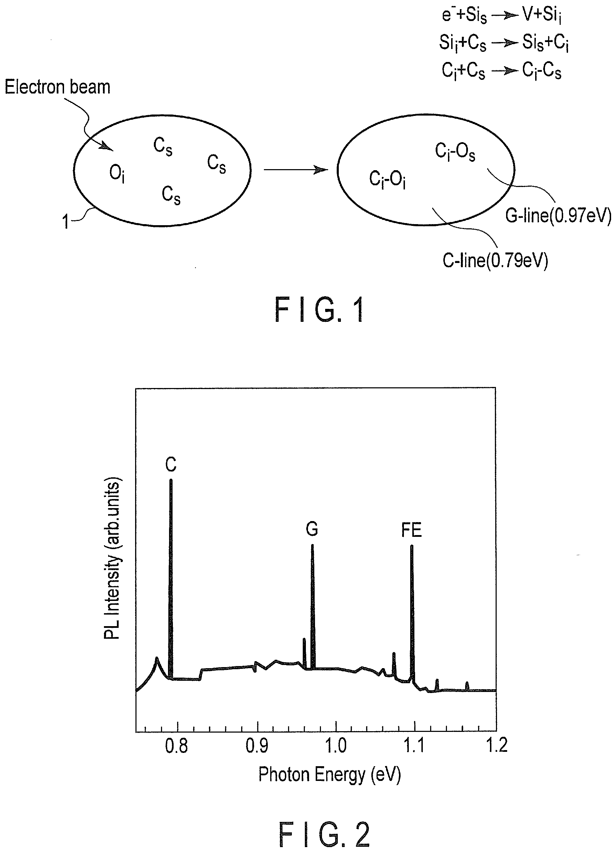

When the semiconductor crystals are irradiated with a particle beam prior to the excitation light irradiation, an impurity in the crystals is rendered luminescence-active. As shown in FIG. 1, for example, when a silicon wafer 1 is irradiated with an electron beam, radiation damage or defects occur in silicon crystals as follows:

Si(s)+e→Si(i)+V

Si(i)+C(s)→Si(s)+C(i)

C(i)+C(s)→Ci-Cs or C(i)+O(i)→Ci-Oi

where V represents a vacancy, and e represents an electron. The index (s) represents that an atom immediately preceding this index is positioned at a lattice point (substitutional). The index (i) represents that an atom immediately preceding this index is positioned between lattice points (interstitial). That is, C(i) represents interstitial carbon, C(s) represents substitutional carbon, and O(i) represents interstitial oxygen. Also, Ci-Cs represents a complex of interstitial carbon and substitutional carbon, and Ci-Oi represents a complex of interstitial carbon and interstitial oxygen.

Thus, the Ci-Oi and Ci-Cs composite detects are formed by the introduction of the primary defects. These Ci-Oi and Ci-Cs defects emit light when irradiated with excitation light, more specifically, a laser beam such as visible light or ultraviolet light. The intensity or intensity ratio of the light emitted by these defects is influenced by, e.g., the number of Ci-Oi and Ci-Cs defects described above. Therefore, information of a carbon impurity in the semiconductor (silicon) can be obtained by analyzing the luminescence intensity or intensity ratio.

FIG. 2 shows an example of the emission spectrum of a silicon wafer. Note that in FIG. 2, the ordinate indicates the luminescence (PL) intensity, and the abscissa indicates the photon energy.

As shown in FIG. 2, the photon energy of the luminescence of the Ci-Cs complex is 0.97 eV, and that of the luminescence of the Ci-Oi complex is 0.79 eV. Note that the photon energy of the free-excitation luminescence of silicon is 1.1 eV, and this value is unique to silicon. The free-excitation luminescence of silicon will be referred to as an FE-line hereinafter. Also, the photon energy of the electron-hole droplet (EHD) luminescence of silicon is 1.08 eV, and this value is unique to silicon.

Next, a saturation voltage estimation method according to this embodiment will be explained.

In the manufacture of a silicon epitaxial wafer, the deposition of a silicon layer by an epitaxial method is generally performed by a batch process. In this batch process, silicon layers as epitaxial layers are formed on a plurality of wafers, e.g., silicon wafers in one deposition process. The silicon epitaxial wafers on which the epitaxial layers are simultaneously formed in the same deposition process, i.e., the silicon epitaxial wafers of the same lot have almost equal carbon concentrations in the epitaxial layers. By contrast, silicon epitaxial wafers on which epitaxial layers are formed in different deposition processes, i.e., silicon epitaxial wafers of different lots sometimes cause variations in carbon concentrations in the epitaxial layers.

The collector-emitter saturation voltage of a semiconductor device fabricated from a silicon epitaxial wafer and including a collector and emitter, e.g., a bipolar transistor such as an insulated gate bipolar-transistor (IGBT) shows a strong correlation with the carbon concentration in an epitaxial layer, if the formation conditions of the device are sufficiently managed. The method according to this embodiment estimates the saturation voltage by using this.

This estimation method will be explained in more detail below.

First, a plurality of first lots each including two or more first silicon epitaxial wafers are prepared. The first lots are obtained by repeating a process of simultaneously forming silicon layers (epitaxial layers) having a carbon concentration of 5 × 10¹⁴ atoms/cm³ or less on a plurality of first wafers by epitaxial growth.

The first lots may also be prepared by using wafers cut out from different ingots as the first wafers. To perform more accurate estimation, however, the first lots are desirably prepared by using wafers cut out from the same ingot as the first wafers.

The dopant concentration of the epitaxial layer is preferably 1 × 10¹⁸ atoms/cm³ or less. This is so because if the dopant concentration is high, no luminescence is sometimes obtained due to the influence of Auger recombination.

Then, one or more of the first silicon epitaxial wafers are extracted from each first lot. Each extracted first silicon epitaxial wafer is irradiated with a particle beam, thereby rendering a carbon impurity in the epitaxial layer luminescence-active. In addition, the epitaxial layers are caused to emit light by irradiation with excitation light, and the intensity or intensity ratio of the luminescence originating from the carbon impurity is obtained. Note that the excitation light irradiation and luminescence intensity measurement are performed at low temperatures, for example, while cooling samples with liquid helium.

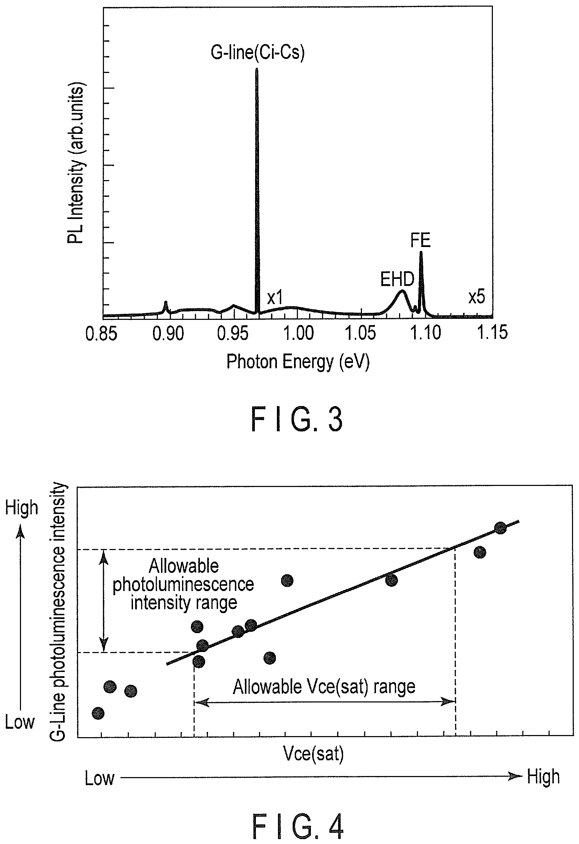

FIG. 3 shows an example of the luminescence spectrum of the epitaxial layer. Referring to FIG. 3, the ordinate indicates the photoluminescence (PL) intensity, and the abscissa indicates the photon energy. Note that for each of the electron-hole droplet (EHD) luminescence and FE luminescence, shown in FIG. 3 is the value obtained by multiplying the measured intensity by five.

Also, one or more semiconductor devices each including a collector and emitter are fabricated from the remaining first silicon epitaxial wafers of each first lot. Here, individual steps such as an annealing step are severely managed so that variations in performances of the semiconductor devices are caused only by variations in characteristics of the first silicon epitaxial wafers. After that, the collector-emitter saturation voltages Vce(sat) of these devices are measured. It is noted that the collector-emitter saturation voltages Vce(sat) is a parameter related to a turn-on voltage V(on-switch) of the device.

The relationship between the luminescence intensity or intensity ratio and the saturation voltage is obtained as described below.

FIG. 4 is a graph showing an example of the relationship between the intensity of luminescence (G-line luminescence) originating from a complex of interstitial carbon and substitutional carbon and the collector-emitter saturation voltage Vce(sat). Referring to FIG. 4, the ordinate indicates the G-line luminescence intensity, and the abscissa indicates the collector-emitter saturation voltage Vce(sat). The relationship between the luminescence intensity and saturation voltage shown in FIG. 4 is obtained by preparing 13 first lots, and performing luminescence intensity measurement, device fabrication, and saturation voltage measurement for each first lot. The number of first lots to be prepared is two or more.

Then, a second lot including two or more second silicon epitaxial wafers is prepared. The second lot is obtained by performing a process of simultaneously forming a plurality of silicon layers (epitaxial layers) having a carbon concentration of 5 × 10¹⁴ atoms/cm³ or less on a plurality of second wafers by epitaxial growth.

The second lot may also be prepared by using, as the second wafers, wafers cut out from an ingot different from the ingot from which the first wafers are cut out. To perform more accurate estimation, however, it is desirable to use, as the second wafers, wafers cut out from the same ingot as that from which the first wafers are cut out. Note that the dopant concentration of the epitaxial layer is preferably 1 × 10¹⁸ atoms/cm³ or less in the second lot as well.

Subsequently, one or more of the second silicon epitaxial wafers are extracted from the second lot. Each extracted second silicon epitaxial wafer is irradiated with a particle beam, thereby rendering a carbon impurity in the epitaxial layers luminescence-active. This particle beam irradiation is performed under the same conditions as those for the first silicon epitaxial wafers.

In addition, the epitaxial layers are caused to emit light by irradiation with excitation light, and the intensity or intensity ratio of the luminescence originating from the carbon impurity is obtained. The excitation light irradiation and luminescence intensity or intensity ratio measurement are performed under the same conditions as those for the first silicon epitaxial wafers.

After that, the intensity or intensity ratio is compared with the above-mentioned relationship, thereby estimating the collector-emitter saturation voltage of a semiconductor device to be fabricated from the remaining second silicon epitaxial wafers of the second lot, which includes a collector and emitter.

In this estimation method, the collector-emitter saturation voltage can be estimated by measuring the luminescence of the silicon layer as an epitaxial layer. Therefore, if it is estimated that, for example, a silicon epitaxial wafer of a certain manufacturing lot does not achieve a saturation voltage within an allowable range, the yield of a semiconductor device formation process can be increased by not supplying the remainders of the wafers in the above manufacturing lot to the process. Also, if it is estimated that a certain silicon epitaxial wafer does not achieve a saturation voltage within an allowable range, it is possible to predict that the manufacturing conditions of the wafer have deviated from optimum conditions. Therefore, this estimation method facilitates maintaining the wafer manufacturing conditions in an optimum state, and can also increase the yield of the wafer manufacturing process.

In this estimation method, it is preferable to use the intensity of the Ci-Cs complex luminescence (0.97 eV: G-line luminescence), among the luminescence originating from the carbon impurity.

The carbon concentration in silicon can be determined by using the intensity of the G-line luminescence or the intensity of the Ci-Oi complex luminescence (0.79 eV; to be referred to as a C-line luminescence hereinafter). However, the oxygen concentration of a silicon epitaxial layer is a low concentration of 1 × 10¹⁶ atoms/cm³ or less. Further, the oxygen concentrations of epitaxial layers epitaxially grown under the same conditions can be regarded as almost constant. Thus, in the case where the G-line luminescence is utilized, a higher luminescence intensity can be obtained as compared with the case where the C-line luminescence is utilized, and the C-line luminescence does not interfere with the determination. Accordingly, it is favorable to use the intensity of the G-line luminescence.

When using the intensity ratio instead of the intensity of luminescence originating from the carbon impurity in the above-mentioned estimation method, this intensity ratio is preferably the ratio of the intensity of luminescence originating from the carbon impurity to the intensity of luminescence originating from silicon, e.g., the ratio of the intensity of the G-line luminescence to that of the FE-line luminescence, or the ratio of the intensity of the G-line luminescence to the intensity of EHD luminescence of silicon. When using these intensity ratios, it is possible to correct, e.g., the influence of surface recombination, a measurement error, and an error resulting from a measurement day, and obtain the above-mentioned relationship with high accuracy.

As the particle beam (high-energy particles) that irradiates the silicon epitaxial wafer and luminescence-activates the carbon impurity, it is possible to use, e.g., an electron beam, a proton beam, or various ion beams.

Since, however, protons or ions are particles larger than electrons, they not only introduce monovacancies (V) but also form many secondary defects such as divacancies. If many secondary defects such as divacancies are formed, luminescence other than that originating from the carbon impurity increases. Examples are luminescence of interstitial silicon, luminescence caused by crystal strain, and luminescence originating from various irradiation damages. In this case, the amount of introduction of non-radiative centers that have a defect level but do not emit light also increases, and the number of carriers capable of contributing to luminescence originating from the carbon impurity reduces. When luminescence irrelevant to carbon and the number of non-radiative centers are reduced, the intensity of luminescence originating from the carbon impurity more accurately reflects the carbon concentration of the epitaxial layer. Accordingly, an electron beam is most suitable for the particle beam.

The dose of the electron beam is preferably 1 × 10¹³ electrons/cm² or more. This is so in order to sufficiently cause luminescence-activation of carbon existing at a maximum concentration of 5 × 10¹⁴ atoms/cm³ in the epitaxial layer, so as to accurately measure the luminescence intensity.

The dose of the electron beam is preferably 1 × 10¹⁷ electrons/cm² or less. This is so because if the dose is too high, irradiation damage to the wafer increases, the number of non-radiative centers increases, and the luminescence intensity decreases.

The wavelength of the excitation light is appropriately selected in accordance with the thickness of the epitaxial layer. This is so because the depth of penetration of the excitation light to silicon depends on the wavelength. For example, the wavelength of the excitation light is preferably 650 nm or less when the thickness of the epitaxial layer is 10 µm or more. Note that if the epitaxial layer is thin, generated carriers may flow into the silicon substrate instead of the epitaxial layer depending on the wavelength. In this case, the luminescence intensity does not accurately reflect the carbon concentration of the epitaxial layer.

A silicon epitaxial wafer manufacturing method according to this embodiment will now be explained.

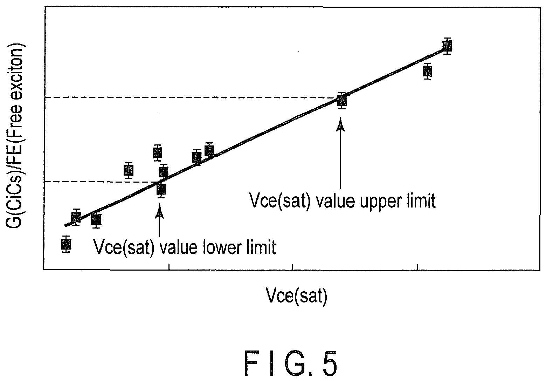

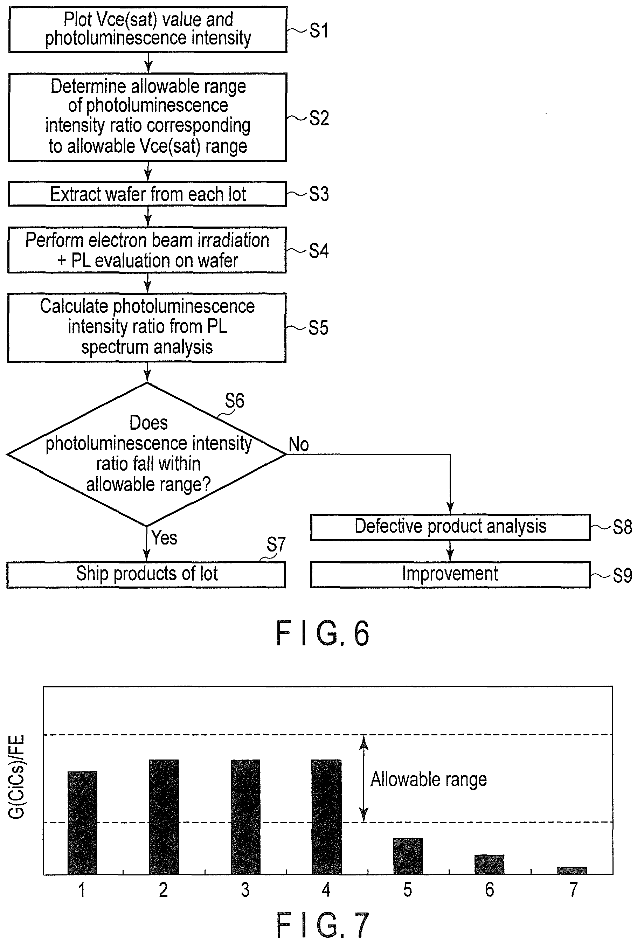

FIG. 5 is a graph showing an example of the relationship between the ratio of the G-line luminescence intensity to the FE luminescence intensity and the collector-emitter saturation voltage Vce(sat). FIG. 6 is a flowchart showing the silicon epitaxial wafer manufacturing method according to the embodiment of the present invention. FIG. 7 is a graph showing an example of the ratio of the G-line luminescence intensity to the FE luminescence intensity.

This manufacturing method uses the above-described estimation method. That is, the relationship between the luminescence intensity or intensity ratio and the saturation voltage is first obtained in the same manner as in the above-described estimation method (step S1 in FIG. 6).

Then, as shown in FIG. 4, a second allowable range (second standard) of the luminescence intensity or intensity ratio is obtained by comparing a predetermined first allowable range (first standard) of the collector-emitter saturation voltage with the above-mentioned relationship (step S2 in FIG. 6). Note that step S2 can also be omitted.

Subsequently, in the same manner as in the above-described estimation method, a second lot is prepared, and some second silicon epitaxial wafers are extracted from the second lot (step S3 in FIG. 6). A carbon impurity in epitaxial layers is rendered luminescence-active by irradiating the extracted second silicon epitaxial wafers with a particle beam, the epitaxial layers are then caused to emit light by irradiation with excitation light, and a luminescence spectrum is measured (step S4 in FIG. 6). In addition, the intensity or intensity ratio of luminescence originating from the carbon impurity is obtained from this luminescence spectrum (step S5 in FIG. 6).

The quality of the second silicon epitaxial wafers of the second lot is determined from the intensity or intensity ratio, the above-mentioned relationship, and the predetermined allowable range of the collector-emitter saturation voltage. For example, as shown in FIG. 7, it is determined that the second silicon epitaxial wafers of the second lot are good products if the intensity or intensity ratio falls within the second allowable range, and it is determined that the second silicon epitaxial wafers of the second lot are defective products if the intensity or intensity ratio falls outside the second allowable range (step S6 in FIG. 6). Alternatively, a saturation voltage is estimated by comparing the intensity or intensity ratio with the above-mentioned relationship. If this saturation voltage falls within the first allowable range (samples 1 to 4 in FIG. 7), it is determined that the second silicon epitaxial wafers of the second lot are good products. If this saturation voltage falls outside the first allowable range (samples 5 to 7 in FIG. 7), it is determined that the second silicon epitaxial wafers of the second lot are defective products.

The second lot found to be good is shipped (step S7 in FIG. 6). For the second lot found to be defective, the cause of the defect is analyzed by, e.g., analyzing the second silicon epitaxial wafers, or checking the conditions of the manufacturing process (step S8 in FIG. 6). Based on the result, the silicon epitaxial wafer manufacturing process is optimized (step S9 in FIG. 6).

In this manufacturing method, whether a semiconductor device having a collector-emitter saturation voltage falling within an allowable range can be fabricated from a silicon epitaxial wafer can be determined by measuring the luminescence of a silicon layer as an epitaxial layer of the wafer. That is, the quality of the silicon epitaxial wafer can be determined before the semiconductor device is formed. Accordingly, the yield of the formation process of the semiconductor device increases. Also, if a given silicon epitaxial wafer is a defective product, it is possible to predict that the manufacturing conditions of the wafer have deviated from optimum conditions. Therefore, this manufacturing method facilitates maintaining the wafer manufacturing conditions in an optimum state, and can also increase the yield of the wafer manufacturing process.

Examples of the present invention will be described below.

### [Example 1]

Silicon layers (epitaxial layers) each having a thickness of 50 µm, a dopant concentration of 1 × 10¹⁴ atoms/cm³, and a carbon concentration of 5 × 10¹⁴ atoms/cm³ or less were simultaneously formed by epitaxial growth on two silicon wafers (polished wafers) having mirror-polished surfaces, thereby obtaining two silicon epitaxial wafers.

One of the silicon epitaxial wafers was irradiated with an electron beam in the atmosphere. The dose of the electron beam was set at 1 × 10¹⁵ electrons/cm². This electron beam irradiation was performed such that the wafer temperature did not exceed 100°C. Thus, the carbon impurity in the epitaxial layer was rendered luminescence-active.

After that, low-temperature luminescence measurement was performed on this silicon epitaxial wafer. More specifically, the wafer was dipped in 4.2-K liquid helium and irradiated with an excitation laser beam (visible light) having a wavelength of 532 nm such that the intensity on the epitaxial layer surface was 100 mW, and the luminescence spectrum was measured. The ratio of the G-line luminescence intensity to the FE luminescence intensity was obtained from this luminescence spectrum.

Subsequently, a semiconductor device including a bipolar transistor was fabricated from the other one of the above-mentioned silicon epitaxial wafers, and the collector-emitter saturation voltage Vce(sat) of this transistor was measured.

A series of operations including the manufacture of the silicon epitaxial wafers, the luminescence-activation, the measurement of the luminescence spectrum, the formation of the semiconductor device, and the saturation voltage measurement were repeated. The correlation graph shown in FIG. 5 was obtained by plotting the obtained data, i.e., the ratio of the G-line luminescence intensity to the FE luminescence intensity and the collector-emitter saturation voltage Vce(sat).

A plurality of silicon epitaxial wafers were simultaneously manufactured under the same conditions as for the above-mentioned silicon epitaxial wafers. This manufacturing process was repeated, and one wafer was extracted from each manufacturing lot. Electron beam irradiation and low-temperature luminescence measurement were performed on each of the extracted wafers under the same conditions as described above. Thus, the ratio of the G-line luminescence intensity to the FE luminescence intensity was obtained for each manufacturing lot. The saturation voltage Vce(sat) was predicted by comparing these ratios to the relationship shown in FIG. 5. After that, only lots each having the saturation voltage Vce(sat) falling within a required range were shipped.

At the shipping destination, the above-mentioned semiconductor device was manufactured from the silicon epitaxial wafer of each shipped lot, and the collector-emitter saturation voltage Vce(sat) was measured. Consequently, all the saturation voltages Vce(sat) of the devices fabricated from the wafers of the shipped lots fell within the required range.

### [Example 2]

Silicon epitaxial wafers were obtained following the same procedures as in Example 1 except that silicon layers each having a thickness of 1 µm, a dopant concentration of 1 × 10¹⁴ atoms/cm³, and a carbon concentration of 5 × 10¹⁴ atoms/cm³ or less were formed as epitaxial layers. The relationship between the luminescence intensity ratio and saturation voltage Vce(sat) was obtained following the same procedures as in Example 1 except that these silicon epitaxial wafers were used, and ultraviolet light having a wavelength of 355 nm was used as the excitation laser beam.

Then, a plurality of silicon epitaxial wafers were simultaneously manufactured under the same conditions as for the above-mentioned silicon epitaxial wafers. This manufacturing process was repeated, and one wafer was extracted from each manufacturing lot. Electron beam irradiation and low-temperature luminescence measurement were performed on each extracted wafer under the same conditions as described above. Thus, the ratio of the G-line luminescence intensity to the FE luminescence intensity was obtained for each manufacturing lot. The saturation voltage Vce(sat) was predicted by comparing these ratios to the above-mentioned relationship. After that, only lots each having the saturation voltage Vce(sat) falling within a required range were shipped.

At the shipping destination, the above-mentioned semiconductor device was manufactured from the silicon epitaxial wafer of each shipped lot, and the collector-emitter saturation voltage Vce(sat) was measured. Consequently, all the saturation voltages Vce(sat) of the devices fabricated from the wafers of the shipped lots fell within the required range.

### [Comparative Example 1]

Silicon epitaxial wafers were obtained following the same procedures as in Example 1 except that silicon layers each having a thickness of 50 µm, a dopant concentration of 1 × 10¹⁴ atoms/cm³, and a carbon concentration of 5 × 10¹⁴ atoms/cm³ or less were formed as epitaxial layers. An attempt was made to obtain the relationship between the luminescence intensity ratio and saturation voltage Vce(sat) following the same procedures as in Example 1 except that these silicon epitaxial wafers were used, and the electron beam dose was set at 1 × 10¹⁸ electrons/cm³. Since the electron beam dose was excessive, however, the number of non-radiative centers increased, and the number of carriers capable of contributing to luminescence desiring from carbon reduced, so the luminescence intensity decreased as a whole. As a consequence, for some silicon epitaxial wafers, the intensity of luminescence originating from carbon became lower than the detection limit, and it was impossible to obtain the relationship between the luminescence intensity ratio and saturation voltage Vce(sat).

### [Comparative Example 2]

Silicon epitaxial wafers were obtained following the same procedures as in Example 1 except that silicon layers each having a thickness of 50 µm, a dopant concentration of 2 × 10¹⁸ atoms/cm³, and a carbon concentration of 5 × 10¹⁴ atoms/cm³ or less were formed as epitaxial layers. An attempt was made to obtain the relationship between the luminescence intensity ratio and saturation voltage Vce(sat) following the same procedures as in Example 1 except that these silicon epitaxial wafers were used. However, no luminescence was obtained at all, i.e., there was only noise, so it was impossible to obtain the relationship between the luminescence intensity ratio and saturation voltage Vce(sat).

### [Comparative Example 3]

Silicon epitaxial wafers were obtained following the same procedures as in Example 1 except that silicon layers each having a thickness of 1 µm, a dopant concentration of 1 × 10¹⁴ atoms/cm³, and a carbon concentration of 5 × 10¹⁴ atoms/cm³ or less were formed as epitaxial layers. An attempt was made to obtain the relationship between the luminescence intensity ratio and saturation voltage Vce(sat) following the same procedures as in Example 1 except that these silicon epitaxial wafers were used. However, it was impossible to obtain the luminescence spectrum of the epitaxial layer because the depth of penetration of an excitation laser beam having a wavelength of 532 nm to silicon was 2.5 µm.

## Claims

1. A saturation voltage estimation method comprising:
a first step of preparing a plurality of first lots each including two or more first silicon epitaxial wafers, the plurality of first lots being obtained by performing, a plurality of number of times, a process of simultaneously forming silicon layers having a carbon concentration of 5 × 10¹⁴ atoms/cm³ or less on two or more first wafers by epitaxial growth;
a second step of performing, for each of the plurality of first lots, irradiation of one or more of the two or more first silicon epitaxial wafers with a particle beam to render a carbon impurity in the silicon layer luminescence-active, irradiation of the silicon layer with excitation light to cause the luminescence, measurement of an intensity or intensity ratio of luminescence originating from the carbon impurity, fabrication of one or more semiconductor devices each including a collector and emitter from the rest of the two or more first silicon epitaxial wafers, and measurement of a collector-emitter saturation voltage of each of the devices, thereby obtaining a relationship between the intensity or intensity ratio and the saturation voltage;
a third step of preparing a second lot including two or more second silicon epitaxial wafers, the second lot being obtained by performing a process of simultaneously forming silicon layers having a carbon concentration of 5 × 10¹⁴ atoms/cm³ or less on two or more second wafers by epitaxial growth; and
a fourth step of irradiating one or more of the two or more second silicon epitaxial wafers with a particle beam to render a carbon impurity in the silicon layer luminescence-active, irradiating the silicon layer with excitation light to cause the luminescence, measuring an intensity or intensity ratio of luminescence originating from the carbon impurity, and comparing the intensity or intensity ratio measured on the one or more second silicon epitaxial wafers with the relationship to estimate a collector-emitter saturation voltage of a semiconductor device to be fabricated from the rest of the two or more second silicon epitaxial wafers and including a collector and emitter.

2. The method according to claim 1, wherein in each of the second and fourth steps, the intensity is an intensity of luminescence originating from a complex of interstitial carbon and substitutional carbon, and the intensity ratio is a ratio of the intensity of the luminescence originating from the complex of interstitial carbon and substitutional carbon to an intensity of free-exciton luminescence of silicon, or a ratio of the intensity of the luminescence originating from the complex of interstitial carbon and substitutional carbon to an intensity of electron-hole droplet luminescence of silicon.

3. The method according to claim 1 or 2, wherein the first and second wafers are cut out from the same ingot.

4. The method according to any one of claims 1 to 3, wherein in each of the second and fourth steps, the particle beam is an electron beam, and a dose of the electron beam is 1 × 10¹³ electrons/cm² to 1 × 10¹⁷ electrons/cm².

5. The method according to any one of claims 1 to 4, wherein a dopant concentration of the silicon layer is 1 × 10¹⁸ atoms/cm³ or less in each of the two or more first silicon epitaxial wafers and the two or more second silicon epitaxial wafers.

6. A silicon epitaxial wafer manufacturing method comprising:
a first step of preparing a plurality of first lots each including two or more first silicon epitaxial wafers, the plurality of first lots being obtained by performing, a plurality of number of times, a process of simultaneously forming silicon layers having a carbon concentration of 5 × 10¹⁴ atoms/cm³ or less on two or more first wafers by epitaxial growth;
a second step of performing, for each of the plurality of first lots, irradiation of one or more of the two or more first silicon epitaxial wafers with a particle beam to render a carbon impurity in the silicon layer luminescence-active, irradiation of the silicon layer with excitation light to cause the luminescence, measurement of an intensity or intensity ratio of luminescence originating from the carbon impurity, fabrication of one or more semiconductor devices each including a collector and emitter from the rest of the two or more first silicon epitaxial wafers, and measurement of a collector-emitter saturation voltage of each of the devices, thereby obtaining a relationship between the intensity or intensity ratio and the saturation voltage;
a third step of preparing a second lot including two or more second silicon epitaxial wafers, the second lot being obtained by performing a process of simultaneously forming silicon layers having a carbon concentration of 5 × 10¹⁴ atoms/cm³ or less on two or more second wafers by epitaxial growth; and
a fourth step of irradiating one or more of the two or more second silicon epitaxial wafers with a particle beam to render a carbon impurity in the silicon layer luminescence-active, irradiating the silicon layer with excitation light to cause the luminescence, measuring an intensity or intensity ratio of luminescence originating from the carbon impurity, and determining quality of the two or more second silicon epitaxial wafers from the intensity or intensity ratio measured on the one or more second silicon epitaxial wafers, the relationship, and a predetermined allowable range of a collector-emitter saturation voltage.

7. The method according to claim 6, wherein in each of the second and fourth steps, the intensity is an intensity of luminescence originating from a complex of interstitial carbon and substitutional carbon, and the intensity ratio is a ratio of the intensity of the luminescence originating from the complex of interstitial carbon and substitutional carbon to an intensity of free-exciton luminescence of silicon, or a ratio of the intensity of the luminescence originating from the complex of interstitial carbon and substitutional carbon to an intensity of electron-hole droplet luminescence of silicon.

8. The method according to claim 6 or 7, wherein the first and the second wafers are cut out from the same ingot.

9. The method according to any one of claims 6 to 8, wherein in each of the second and fourth steps, the particle beam is an electron beam, and a dose of the electron beam is 1 × 10¹³ electrons/cm² to 1 × 10¹⁷ electrons/cm².

10. The method according to any one of claims 6 to 9, wherein a dopant concentration of the silicon layer is 1 × 10¹⁸ atoms/cm³ or less in each of the two or more first silicon epitaxial wafers and the two or more second silicon epitaxial wafers.

## Patentansprüche

1. Sättigungsspannungsschätzverfahren mit:
einem ersten Schritt zum Bereitstellen mehrerer erster Lose, die jeweils zwei oder mehr erste Silizium-Epitaxiewafer aufweisen, wobei die mehreren ersten Lose durch mehrmaliges Ausführen eines Prozesses zum gleichzeitigen Ausbilden von Siliziumschichten mit einer Kohlenstoffkonzentration von 5×10¹⁴ Atomen/cm³ oder weniger auf zwei oder mehr ersten Wafern durch epitaktisches Wachstum erhalten werden;
einem zweiten Schritt zum Bestrahlen eines oder mehrerer der zwei oder mehr ersten Silizium-Epitaxiewafer mit einem Teilchenstrahl für jedes der mehreren ersten Lose, um eine Kohlenstoffverunreinigung in der Siliziumschicht lumineszenzaktiv zu machen, Bestrahlen der Siliziumschicht mit Anregungslicht, um die Lumineszenz auszulösen, Messen einer Intensität oder eines Intensitätsverhältnisses von Lumineszenz, die von der Kohlenstoffverunreinigung stammt, Herstellen eines oder mehrerer Halbleiterbauelemente, die jeweils einen Kollektor und einen Emitter aufweisen, von den restlichen der zwei oder mehr ersten Silizium-Epitaxiewafer und Messen einer Kollektor-Emitter-Sättigungsspannung jedes der Halbleiterbauelemente, um eine Beziehung zwischen der Intensität oder dem Intensitätsverhältnis und der Sättigungsspannung zu erhalten;
einem dritten Schritt zum Bereitstellen eines zweiten Loses, das zwei oder mehr zweite Silizium-Epitaxiewafer aufweist, wobei das zweite Los durch Ausführen eines Prozesses zum gleichzeitigen Ausbilden von Siliziumschichten mit einer Kohlenstoffkonzentration von 5×10¹⁴ Atomen/cm³ oder weniger auf zwei oder mehr zweiten Wafern durch epitaktisches Wachstum erhalten wird; und
einem vierten Schritt zum Bestrahlen eines oder mehrerer der zwei oder mehr zweiten Silizium-Epitaxiewafer mit einem Teilchenstrahl, um eine Kohlenstoffverunreinigung in der Siliziumschicht lumineszenzaktiv zu machen, Bestrahlen der Siliziumschicht mit Anregungslicht, um die Lumineszenz auszulösen, und Messen einer Intensität oder eines Intensitätsverhältnisses von Lumineszenz, die von der Kohlenstoffverunreinigung stammt, und Vergleichen der Intensität oder des Intensitätsverhältnisses, die/das bezüglich dem einen oder den mehreren zweiten Silizium-Epitaxiewafern gemessen wird, mit der Beziehung, um eine Kollektor-Emitter-Sättigungsspannung eines Halbleiterbauelements zu schätzen, das aus den restlichen der zwei oder mehr zweiten Silizium-Epitaxiewafer hergestellt werden soll und einen Kollektor und einen Emitter aufweist.

2. Verfahren nach Anspruch 1, wobei in jedem unter dem zweiten und dem vierten Schritt die Intensität eine Intensität von Lumineszenz ist, die von einem Komplex von interstitiellem Kohlenstoff und Substitutionskohlenstoff stammt, und wobei das Intensitätsverhältnis ein Verhältnis zwischen der Intensität der Lumineszenz, die von dem Komplex des interstitiellen Kohlenstoffs und des Substitutionskohlenstoffs stammt, und einer Intensität der Lumineszenz freier Exzitonen von Silizium ist, oder ein Verhältnis zwischen der Intensität der Lumineszenz, die von dem Komplex des interstitiellen Kohlenstoffs und des Substitutionskohlenstoff stammt, und einer Intensität der Elektron-Loch-Tröpfchen-Lumineszenz von Silizium ist.

3. Verfahren nach Anspruch 1 oder 2, wobei der erste und der zweite Wafer aus demselben Block geschnitten werden.

4. Verfahren nach einem der Ansprüche 1 bis 3, wobei in jedem unter dem zweiten und dem vierten Schritt der Teilchenstrahl ein Elektronenstrahl ist, und wobei eine Dosis des Elektronenstrahls 1×10¹³ Elektronen/cm² bis 1×10¹⁷ Elektronen/cm² beträgt.

5. Verfahren nach einem der Ansprüche 1 bis 4, wobei eine Dotierstoffkonzentration der Siliziumschicht in jedem der zwei oder mehr ersten Silizium-Epitaxiewafer und der zwei oder mehr zweiten Silizium-Epitaxiewafer 1×10¹⁸ Atome/cm³ oder weniger beträgt.

6. Verfahren zum Herstellen eines Silizium-Epitaxiewafers, mit:
einem ersten Schritt zum Bereitstellen mehrerer erster Lose, die jeweils zwei oder mehr erste Silizium-Epitaxiewafer aufweisen, wobei die mehreren ersten Lose durch mehrmaliges Ausführen eines Prozesses zum gleichzeitigen Ausbilden von Siliziumschichten mit einer Kohlenstoffkonzentration von 5×10¹⁴ Atomen/cm³ oder weniger auf zwei oder mehr ersten Wafern durch epitaktisches Wachstum erhalten werden;
einem zweiten Schritt zum Bestrahlen eines oder mehrerer der zwei oder mehr ersten Silizium-Epitaxiewafer mit einem Teilchenstrahl für jedes der mehreren ersten Lose, um eine Kohlenstoffverunreinigung in der Siliziumschicht lumineszenzaktiv zu machen, Bestrahlen der Siliziumschicht mit Anregungslicht, um die Lumineszenz auszulösen, Messen einer Intensität oder eines Intensitätsverhältnisses von Lumineszenz, die von der Kohlenstoffverunreinigung stammt, Herstellen eines oder mehrerer Halbleiterbauelemente, die jeweils einen Kollektor und einen Emitter aufweisen, von den restlichen der zwei oder mehr ersten Silizium-Epitaxiewafer und Messen einer Kollektor-Emitter-Sättigungsspannung jedes der Halbleiterbauelemente, um eine Beziehung zwischen der Intensität oder dem Intensitätsverhältnis und der Sättigungsspannung zu erhalten;
einem dritten Schritt zum Bereitstellen eines zweiten Loses, das zwei oder mehr zweite Silizium-Epitaxiewafer aufweist, wobei das zweite Los durch Ausführen eines Prozesses zum gleichzeitigen Ausbilden von Siliziumschichten mit einer Kohlenstoffkonzentration von 5×10¹⁴ Atomen/cm³ oder weniger auf zwei oder mehr zweiten Wafern durch epitaktisches Wachstum erhalten wird; und
einem vierten Schritt zum Bestrahlen eines oder mehrerer der zwei oder mehr zweiten Silizium-Epitaxiewafer mit einem Teilchenstrahl, um eine Kohlenstoffverunreinigung in der Siliziumschicht lumineszenzaktiv zu machen, Bestrahlen der Siliziumschicht mit Anregungslicht, um die Lumineszenz auszulösen, und Messen einer Intensität oder eines Intensitätsverhältnisses von Lumineszenz, die von der Kohlenstoffverunreinigung stammt, und Bestimmen der Qualität der zwei oder mehr zweiten Silizium-Epitaxiewafer von der Intensität oder dem Intensitätsverhältnis, die/das bezüglich dem einen oder den mehreren zweiten Silizium-Epitaxiewafern gemessen wird, der Beziehung, und eines vorgegebenen Toleranzbereichs einer Kollektor-Emitter-Sättigungsspannung.

7. Verfahren nach Anspruch 6, wobei in jedem unter dem zweiten und dem vierten Schritt die Intensität eine Intensität von Lumineszenz ist, die von einem Komplex von interstitiellem Kohlenstoff und Substitutionskohlenstoff stammt, und wobei das Intensitätsverhältnis ein Verhältnis zwischen der Intensität der Lumineszenz, die von dem Komplex des interstitiellen Kohlenstoffs und des Substitutionskohlenstoffs stammt, und einer Intensität der Lumineszenz freier Exzitonen von Silizium ist, oder ein Verhältnis zwischen der Intensität der Lumineszenz, die von dem Komplex des interstitiellen Kohlenstoffs und des Substitutionskohlenstoffs stammt, und einer Intensität der Elektron-Loch-Tröpfchen-Lumineszenz von Silizium ist.

8. Verfahren nach Anspruch 6 oder 7, wobei der erste und der zweite Wafer aus demselben Block geschnitten werden.

9. Verfahren nach einem der Ansprüche 6 bis 8, wobei in jedem unter dem zweiten und dem vierten Schritt der Teilchenstrahl ein Elektronenstrahl ist, und wobei eine Dosis des Elektronenstrahls 1×10¹³ Elektronen/cm² bis 1×10¹⁷ Elektronen/cm² beträgt.

10. Verfahren nach einem der Ansprüche 6 bis 9, wobei eine Dotierstoffkonzentration der Siliziumschicht in jedem der zwei oder mehr ersten Silizium-Epitaxiewafer und der zwei oder mehr zweiten Silizium-Epitaxiewafer 1×10¹⁸ Atome/cm³ oder weniger beträgt.

## Revendications

1. Procédé de détermination d'une tension de saturation comprenant :
une première étape consistant à préparer une pluralité de premiers lots incluant chacun deux ou plusieurs premières tranches épitaxiales de silicium, la pluralité de premiers lots étant obtenue en réalisant, une pluralité de nombre de fois, un processus de formation simultanée de couches de silicium ayant une concentration en carbone de 5×10¹⁴ atomes/cm³ ou moins sur deux ou plusieurs premières tranches par croissance épitaxiale ;
une deuxième étape consistant à réaliser, pour chaque lot de la pluralité de premiers lots, une irradiation d'une ou plusieurs des deux ou plusieurs premières tranches épitaxiales de silicium avec un faisceau de particules pour rendre luminescente une impureté de carbone dans la couche de silicium, une irradiation de la couche de silicium avec une lumière d'excitation pour provoquer la luminescence, une mesure d'une intensité ou d'un taux d'intensité de luminescence provenant de l'impureté de carbone, la fabrication d'un ou plusieurs dispositifs à semi-conducteur incluant chacun un collecteur et un émetteur à partir du reste des deux ou plusieurs premières tranches épitaxiales de silicium, et une mesure d'une tension de saturation collecteur-émetteur de chacun des dispositifs, en obtenant de cette manière une relation entre l'intensité ou le taux d'intensité et la tension de saturation ;
une troisième étape consistant à préparer un deuxième lot incluant deux ou plusieurs deuxièmes tranches épitaxiales de silicium, le deuxième lot étant obtenu en réalisant un processus de formation simultanée de couches de silicium ayant une concentration en carbone de 5×10¹⁴ atomes/cm³ ou moins sur deux ou plusieurs deuxièmes tranches par croissance épitaxiale ; et
une quatrième étape consistant à irradier une ou plusieurs des deux ou plusieurs deuxièmes tranches épitaxiales de silicium avec un faisceau de particules pour rendre luminescente une impureté de carbone dans la couche de silicium, irradier la couche de silicium avec une lumière d'excitation pour provoquer la luminescence, mesurer une intensité ou un taux d'intensité de luminescence provenant de l'impureté de carbone, et comparer l'intensité ou le taux d'intensité mesuré sur les une ou plusieurs deuxièmes tranches épitaxiales de silicium avec la relation pour estimer une tension de saturation collecteur-émetteur d'un dispositif à semi-conducteur devant être fabriqué à partir du reste des deux ou plusieurs deuxièmes tranches épitaxiales de silicium et incluant un collecteur et un émetteur.

2. Procédé selon la revendication 1, dans lequel dans chacune des deuxième et quatrième étapes, l'intensité est une intensité de luminescence provenant d'un complexe de carbone interstitiel et de carbone de substitution, et le taux d'intensité est un rapport de l'intensité de la luminescence provenant du complexe de carbone interstitiel et de carbone de substitution sur une intensité de luminescence sans exciton du silicium, ou un rapport de l'intensité de la luminescence provenant du complexe de carbone interstitiel et de carbone de substitution sur une intensité de luminescence de gouttes d'électrons et de trous de silicium.

3. Procédé selon la revendication 1 ou 2, dans lequel les première et deuxième tranches sont découpées à partir du même lingot.

4. Procédé selon l'une quelconque des revendications 1 à 3, dans lequel dans chacune des deuxième et quatrième étapes, le faisceau de particules est un faisceau d'électrons, et une dose du faisceau d'électrons est de 1x10¹³ électrons/cm² à 1x10¹⁷ électrons/cm².

5. Procédé selon l'une quelconque des revendications 1 à 4, dans lequel une concentration en dopant de la couche de silicium est de 1x10¹⁸ atomes/cm² ou moins dans chacune des deux ou plusieurs premières tranches épitaxiales de silicium et des deux ou plusieurs deuxièmes tranches épitaxiales de silicium.

6. Procédé de fabrication d'une tranche épitaxiale de silicium comprenant :
une première étape consistant à préparer une pluralité de premiers lots incluant chacun deux ou plusieurs premières tranches épitaxiales de silicium, la pluralité de premiers lots étant obtenue en réalisant, une pluralité de nombre de fois, un processus de formation simultanée de couches de silicium ayant une concentration en carbone de 5×10¹⁴ atomes/cm³ ou moins sur deux ou plusieurs premières tranches par croissance épitaxiale ;
une deuxième étape consistant à réaliser, pour chaque lot de la pluralité de premiers lots, une irradiation d'une ou plusieurs des deux ou plusieurs premières tranches épitaxiales de silicium avec un faisceau de particules pour rendre luminescente une impureté de carbone dans la couche de silicium, une irradiation de la couche de silicium avec une lumière d'excitation pour provoquer la luminescence, une mesure d'une intensité ou d'un taux d'intensité de luminescence provenant de l'impureté de carbone, la fabrication d'un ou plusieurs dispositifs à semi-conducteur incluant chacun un collecteur et un émetteur à partir du reste des deux ou plusieurs premières tranches épitaxiales de silicium, et une mesure d'une tension de saturation collecteur-émetteur de chacun des dispositifs, en obtenant de cette manière une relation entre l'intensité ou le taux d'intensité et la tension de saturation ;
une troisième étape consistant à préparer un deuxième lot incluant deux ou plusieurs deuxièmes tranches épitaxiales de silicium, le deuxième lot étant obtenu en réalisant un processus de formation simultanée de couches de silicium ayant une concentration en carbone de 5×10¹⁴ atomes/cm³ ou moins sur deux ou plusieurs deuxièmes tranches par croissance épitaxiale ; et
une quatrième étape consistant à irradier une ou plusieurs des deux ou plusieurs deuxièmes tranches épitaxiales de silicium avec un faisceau de particules pour rendre luminescente une impureté de carbone dans la couche de silicium, irradier la couche de silicium avec une lumière d'excitation pour provoquer la luminescence, mesurer une intensité ou un taux d'intensité de la luminescence provenant de l'impureté de carbone, et déterminer une qualité des deux ou plusieurs deuxièmes tranches épitaxiales de silicium à partir de l'intensité ou du taux d'intensité mesuré sur les une ou plusieurs deuxièmes tranches épitaxiales de silicium, la relation, et une plage admissible prédéterminée d'une tension de saturation collecteur-émetteur.

7. Procédé selon la revendication 6, dans lequel dans chacune des deuxième et quatrième étapes, l'intensité est une intensité de luminescence provenant d'un complexe de carbone interstitiel et de carbone de substitution, et le taux d'intensité est un rapport de l'intensité de la luminescence provenant du complexe de carbone interstitiel et de carbone de substitution sur une intensité de luminescence sans exciton du silicium, ou un rapport de l'intensité de la luminescence provenant du complexe de carbone interstitiel et de carbone de substitution sur une intensité d'une luminescence de gouttes d'électrons et de trous du silicium.

8. Procédé selon la revendication 6 ou 7, dans lequel les première et deuxième tranches sont découpées à partir du même lingot.

9. Procédé selon l'une quelconque des revendications 6 à 8, dans lequel dans chacune des deuxième et quatrième étapes, le faisceau de particules est un faisceau d'électrons, et une dose du faisceau d'électrons est de 1x10¹³ électrons/cm² à 1x10¹⁷ électrons/cm².

10. Procédé selon l'une quelconque des revendications 6 à 9, dans lequel une concentration en dopant de la couche de silicium est de 1x10¹⁸ atomes/cm² ou moins dans chacune des deux ou plusieurs premières tranches épitaxiales de silicium et des deux ou plusieurs deuxièmes tranches épitaxiales de silicium.
